Europäisches Patentamt

European Patent Office

Office européen des brevets

(11) Publication number: **0 226 433
B1**

# EUROPEAN PATENT SPECIFICATION

(45) Date of publication of the patent specification:
07.03.90

(51) Int. Cl.⁴: **H05K 1/00**, H05K 1/11, H01L 23/52

(21) Application number: **86309571.7**

(22) Date of filing: **09.12.86**

(54) **High density printed wiring board.**

(30) Priority: **09.12.85 JP 277580/85**

(43) Date of publication of application:
**24.06.87 Bulletin 87/26**

(45) Publication of the grant of the patent:
**07.03.90 Bulletin 90/10**

(84) Designated Contracting States:
**DE ES GB**

(56) References cited:
**US-A- 4 016 463
US-A- 4 521 449**

**IBM TECHNICAL DISCLOSURE BULLETIN, vol. 27, no. 2, July 1984, pages 1201,1202, New York, US; R.A. MAGEE et al.: "Pinned multilayer ceramic substrate"
IBM TECHNICAL DISCLOSURE BULLETIN, vol. 21, no. 11, April 1979, pages 4491,4492, New York, US; M.R. MARASCH et al.:"Dual-purpose bonding pads for semiconductor package substrates"
ELEKTRONIK, vol. 29, no. 21, Oktober 1980, pages 125-128, Munich, DE; H. KRUMM: "Bessere Leiterplattenausnutzung mit neuem Mehrchip-IC-Gehäuse"**

(73) Proprietor: **FUJITSU LIMITED, 1015, Kamikodanaka Nakahara-ku, Kawasaki-shi Kanagawa 211(JP)**

(72) Inventor: **Seyama, Kiyotaka Fujitsu Ltd Patent Department, Kosugi Fujitsu
Bldg 1812-10 Shimonumabe, Nakahara-ku Kawasaki-shi Kanagawa 211(JP)**

(74) Representative: **Billington, Lawrence Emlyn et al, HASELTINE LAKE & CO Hazlitt House 28 Southampton Buildings Chancery Lane, London WC2A 1AT(GB)**

## Description

The present invention relates to a printed wiring board (printed circuit board) for mounting semiconductor devices.

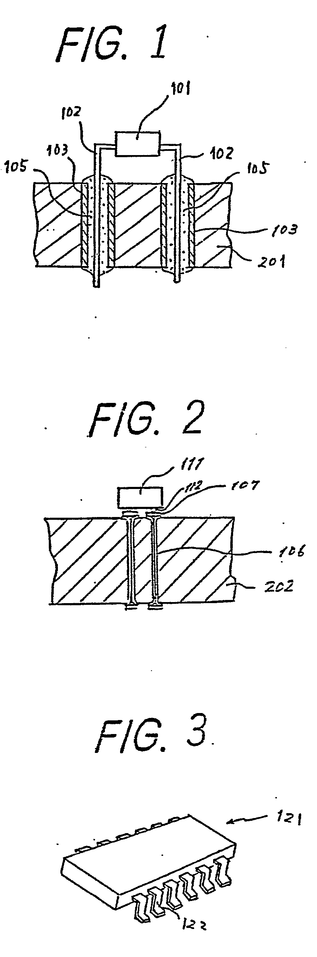

Mechanical parts and electronic parts to be mounted on a printed wiring board (printed circuit board) have in the past been fixed mechanically using through holes provided in the printed wiring board as shown in Fig. 1. Fig. 1 illustrates an electronic part 101 which is fixed to a printed wiring board 201 using through holes 103. In Fig. 1, the electronic part 101 is fixed to the printed wiring board 201 by soldering its leads 102 to the through holes 103 as shown, by solder 105. Although not depicted in Fig. 1, such through holes 103 are connected to internal wires provided in the printed wiring board 201 so that an electronic part 101 is electrically connected to such internal wires by the through holes 102.

However, recently, electronic parts have come to have remarkably high packing density, for example Large Scale Integration (LSI) semiconductor devices, so that a printed wiring board mounting such devices must have high density internal wirings. Therefore, large size through holes rather hinder high packing density of a printed wiring board. As a result, almost all through holes have now been replaced by so-called via holes as illustrated in Fig. 2. In Fig. 2, a high density semiconductor device 111 uses so-called bump terminals (hereinafter referred to as BUMPs) as input or output terminals, and the BUMPs 112 are respectively fixed to pads 107 provided on the via holes with solder. Comparing Figs. 1 and 2, it is clear that the via hole is superior to the through hole in realizing a high packing density of the printed wiring board.

Semiconductor devices packed in flat lead packages are also used widely; in Fig. 3, reference numeral 122 is a flat lead of a flat lead package device 121. In the case of a high density semiconductor device, there is a problem that the transmission rate of input and output signals is affected by the length of the lead. Therefore, recently, semiconductor devices are being packed in a package having BUMPs, and furthermore BUMPs are being applied directly to a semiconductor element without using any package. The former type of semiconductor device having a package is called a semiconductor package device, and the latter type device which uses a semiconductor element directly is called a semiconductor element device. The present invention relates to both types of device.

Through holes and via holes are substantially the same, however a hole having a small size and a pad at the surface of the printed wiring board will be called a via hole henceforth.

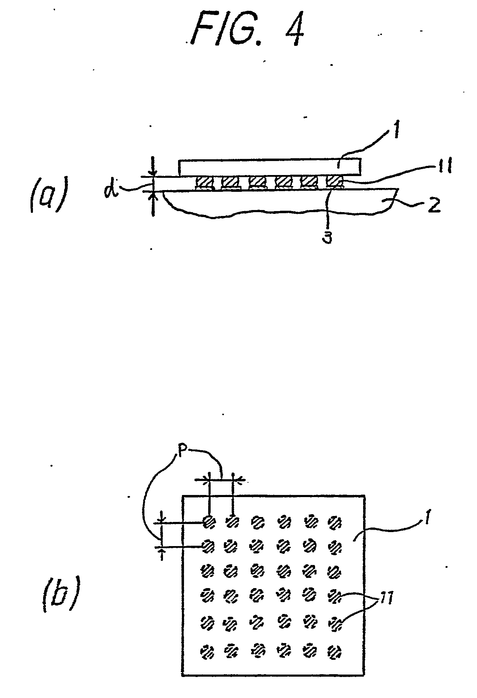

Fig. 4 is a schematic diagram illustrating a semiconductor element device. Fig. 4(a) is a schematic side view of a semiconductor element device 1 mounted on a printed wiring board 2, while Fig. 4(b) is a schematic plan view thereof. In Figs. 4(a) and (b), reference numeral 11 represents BUMPs which are soldered onto terminal pads 3 provided on a surface of a printed wiring board 2 and connected to respective inner circuits (internal wires) of the printed wiring board 2 (not depicted in Fig. 4(a)). Thereby, the semiconductor element device 1 is both electrically connected to the inner circuits and mechanically fixed to the printed wiring board 2, with a distance d being maintained between the upper surface of the printed wiring board 2 and the lower surface of the semiconductor device 1. The distance d is generally 0.2 to 0.3 mm. As shown in Fig. 4(b), the BUMPs 11 are usually arranged in a grid pattern.

In a case in which a semiconductor device is a semiconductor package device, the size of the device body is larger than that of a semiconductor element device but the arrangement of BUMPs, and the structure mounting the device to the printed wiring board, are the same as those in Figs. 4(a) and 4(b).

Thus, BUMPs have been useful for mounting high density semiconductor devices to high density printed wiring boards. However, there are problems with known high density printed wiring boards when the number of BUMPs becomes large.

Generally, the internal wiring connected to each terminal pad has a fixed destination, that is, it makes a connection to a designated circuit of the printed wiring board. Therefore it is not easy to change the internal wiring every time the destination is required to be modified, because the costs for redesigning and manufacturing the modified internal wirings become high.

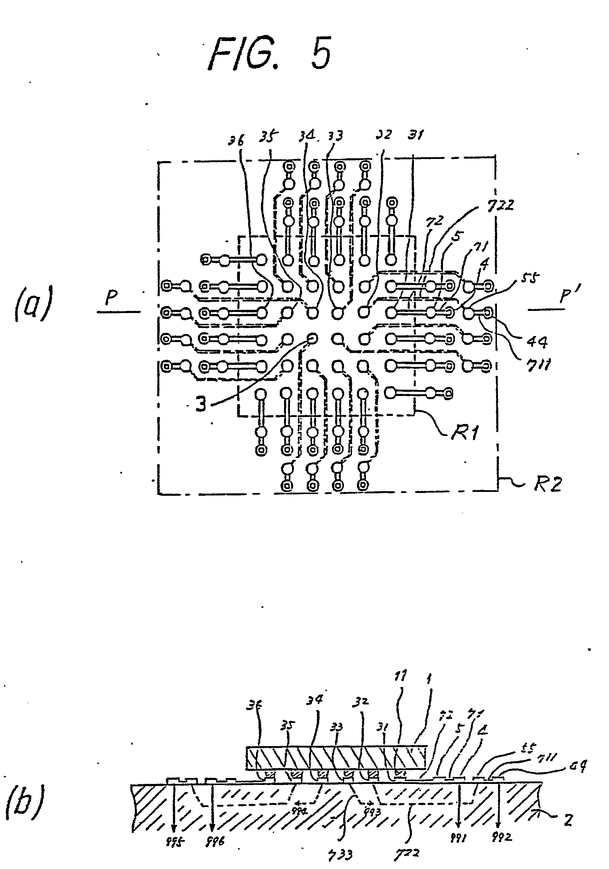

A pad called a modification pad can be provided on the surface of the printed wiring board for modifying the destination of a terminal pad. The modification pad is connected with the terminal pad by wiring internal to the printed wiring board, and is placed near to a via pad. The via pad is connected to a previously designated circuit through the internal wiring and is usually connected to the modification pad by a surface wiring pattern provided on the surface of the printed wiring board. Fig. 5 illustrates modification pads, wiring and wiring patterns provided on and in a high density printed wiring board.

Fig. 5(a) is a top view illustrating terminal pads 3, modification pads 5 and 55, via pads 4 and 44, and wirings and wiring patterns concerned with these pads. Fig. 5(b) is a partial sectional view along a line p–p, shown in Fig. 5(a). In Fig. 5(a), a dashed square R1 indicates a terminal pads region in which the terminal pads are gathered. The reference numerals 3 indicate the terminal pads in general, and the particular terminal pads arranged on the line p–p' are indicated by reference numerals 31, 32, --- and 36 from right to left respectively.

In Figs. 5(a) and 5(b), each of the pads 31 to 36 has associated with it a respective modification pad and via pad. For example, terminal pads 31 and 32 are associated with modification pads 5 and 55 and via pads 4 and 44 respectively. These via pads 4 and 44 are connected to previously designated circuits 991 and 992 through respective internal wirings, and connected to terminal pads 31 and 32 through the modification pads 5 and 55 respectively. That is, the terminal pad 31 is connected with the modification pad 5 by the surface wiring pattern 72, and the modification pad 5 is connected with the via pad 4 by the surface wiring pattern 71, while the terminal pad 32 is connected with the via pad 44 by the surface wiring pattern 711.

The use of the "surface wiring pattern" 722 for the wiring between the terminal pad 31 and the modification pad 5 is only possible because the terminal 31 is on the outside of the terminal pad region. As will be clear, the other terminal pads 32 through 35 inside the terminal pad region must use internal wirings to connect to their respective modification pads. However, in Figs. 5(a) and 5(b), it should be noted that all wirings between the modification pads and via pads only use surface wiring patterns such as pattern 711, and that each modification pad usually functions as a pad relaying electrical connection between the terminal pad and the via pad. In other words, the modification pads, and the surface wiring patterns from the modification pads to the via pads, usually act only to extend the wirings from the terminal pads to the via pads.

However, if it is required to modify the destination of a terminal pad, the modification can be easily performed by cutting the surface wiring pattern between the modification pad and the via pad, and connecting a discrete wire running over the surface of the printed wiring board.

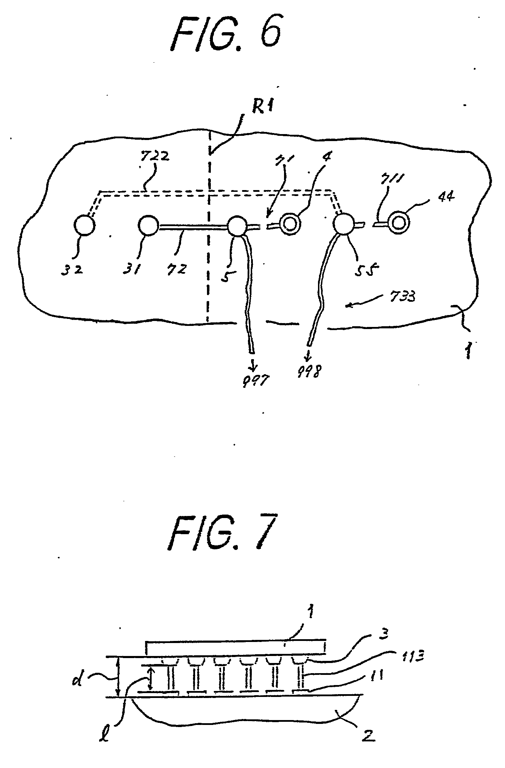

Fig. 6 is a fragmentary plan view of the high density printed wiring board 1 of Fig. 5, illustrating an example of cutting the surface wiring patterns 71 and 711. When the terminal pads 31 and 32 need to be modified so as to connect with other destinations, circuits 997 and 998, respectively, the modification can be performed by cutting the surface wiring patterns 71 and 711 and newly connecting discrete surface wirings to the circuits 997 and 998 respectively on the surface of the printed wiring board 1.

Thus, by providing modification pads and via pads on the outside of the terminal pads region R1 with associated wirings and wiring patterns, destination modification from the terminal pads can be easily performed without doing any redesign or manufacturing a new printed wiring board.

Recently, however, the number of input and output terminals of a high density semiconductor device, hence the number of pads on a high density printed wiring board, has increased to as many as 200 or more. This increase has brought the following problems:

(1) the mounting density of high density semiconductor devices on the high density printed wiring board is lowered because a region R2 (indicated in Fig. 5(a)) for the modification pads and via pads, becomes extended due to the increase in the number of terminal pads;

(2) the high density printed wiring board requires two, three or more layers resulting in increased cost, because the number of internal wirings connecting the terminal pads to the modification pads increases; and

(3) the signal transmission rate of signals in the high density printed wiring board drops, because the internal wirings connecting the terminal pads to the modification pads are lengthened.

In Figs. 4 and 5, the BUMPs 11 of the high density semiconductor device 1 are bonded to the terminal pads 3 of the high density printed wiring board 2 so as to keep a distance "d" of about 0.2 mm–0.3 mm between the device 1 and the board 2 as described above. However, in the case of a high density semiconductor device comprising as many as 200 BUMPs, the distance d is reduced to a small value such as 0.1 mm due for facilitating the bonding process.

In this case, if the device is cooled by boiling of a coolant, boiling bubbles remain within the small gap, lowering the cooling efficiency. Moreover, when the number of BUMPs increases as above, cumulative position errors of pitch p between the BUMPs also increase. In addition, stress is applied to the bonding parts of the BUMPs and terminal pads, due to difference in thermal expansion coefficient between the high density semiconductor device and the high density printed wiring board. As a result, reliability of the joints between the semiconductor device and the printed wiring board is decreased.

With a view to solving these problems, it has been proposed to insert a contact wire between each BUMP and corresponding terminal pad.

Fig. 7 is a schematic side view of a high density semiconductor device mounted on a high density printed wiring board through contact wires 113. The length "L" of the contact wires 113 can be determined appropriately in relation to the number of BUMPs for setting the distance d to 0.5 mm or more.

IBM Technical Disclosure Bulletin, Vol. 27, No. 2, July 1984, discloses a pinned multilayer ceramic substrate having internal wiring layers, headed pins passing through the substrate, and voltage and signal vias connected to the internal wiring layers. The vias are connected to the pins by conductive teardrop-shaped areas on the surface of the substrate.

According to the present invention, there is provided a printed wiring board, for mounting a semiconductor device having input terminals and output terminals, said board including internal wirings and comprising:

a plurality of terminal pads provided on a surface of the printed wiring board for electrical connection to the input and output terminals of the semiconductor device, and forming a terminal pads region on the surface of the printed wiring board; and

a plurality of via pads provided within said terminal pads region such that each via pad is positioned near a respective said terminal pad, for electrically connecting said terminal pads to said internal wirings of the board, each via pad being internally connected to a said internal wiring providing a connection to a previously designated circuit of the board, and being connected with its respective terminal pad; and characterised by:

a plurality of modification pads provided within the terminal pads region, each one being located near a respective terminal pad and via pad for electrically relaying a connection from said terminal pad to a different circuit, not said previously designated circuit, of the printed wiring board.

An embodiment of the present invention may allow modifications, such as a change of the type of high density semiconductor device mounted on a high density printed wiring board, and modification of the destinations of terminals of the high density semiconductor device, to be easily made.

An embodiment of the present invention may provide a high density printed wiring board, having pads and surface wiring patterns which can be easily modified on a surface of the printed wiring board when destination circuits of the semiconductor devices are modified.

An embodiment of the present invention may improve mounting density of high density semiconductor devices on a high density printed wiring board.

An embodiment of the present invention may enable the signal transmission time of signals entering and leaving a high density semiconductor device mounted on a high density printed wiring board, to be reduced.

An embodiment of the present invention may simplify the internal wirings of a printed wiring board onto which high density semiconductor devices are mounted, thereby reducing the cost of the printed wiring board.

In an embodiment of the invention, via pads are arranged in the vicinity of respective terminal pads inside the terminal pads region, and modification pads are arranged in the vicinity of respective terminal pads inside the terminal pads region.

Reference is made, by way of example, to the accompanying drawings in which:

Fig. 1 is a partial sectional view illustrating fixing of components to a printed wiring board using through holes;

Fig. 2 is a partial sectional view illustrating fixing of components to a printed wiring board using via holes;

Fig. 3 is a schematic perspective view of a semiconductor device packed in a flat lead package;

Fig. 4(a) is a schematic side view of a high density semiconductor device comprising BUMPs, mounted to a high density printed wiring board;

Fig. 4(b) is a schematic plan view of a high density semiconductor device, illustrating arrangement of BUMPs;

Fig. 5(a) is a schematic partial plan view of a high density printed wiring board comprising modification pads and via pads;

Fig. 5(b) is a schematic partial sectional view corresponding to Fig. 5(a);

Fig. 6 is a schematic partial plan view of a high density printed wiring board, illustrating modification of destinations of terminal pads;

Fig. 7 is a schematic side view of a high density semiconductor device mounted to a high density printed wiring board by contact wires;

Fig. 8 is a schematic perspective view of a high density printed wiring board, having mounted to it a high density semiconductor device;

Fig. 9 is a partial schematic plan view of a high density printed wiring board;

Fig. 10 is a schematic partial plan view of a high density wiring board which illustrates an embodiment of the present invention; and

Fig. 11 is a schematic plan view of a high density printed wiring board which illustrates a detail of the Fig. 10 embodiment of the present invention.

Embodiments of the present invention involve totally or partially shifting the modification pads and the via pads, previously located outside the terminal pads region R1 of a high density printed wiring board, to inside the region R1.

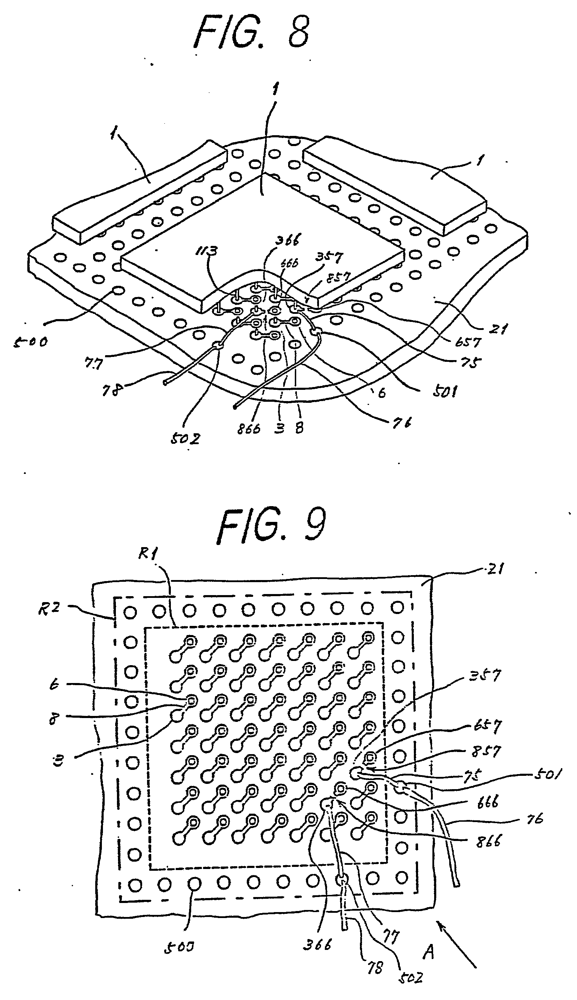

Before explaining the present invention, there will be explained with reference to Figs. 8 and 9 a board in which all the via pads are provided inside the region R1, and the modification pads are provided outside and nearby the region R1 in a line.

Fig. 8 is a partial perspective view of the board 21 mounting the devices 1, observed from the direction of arrow A indicated in the plan view of Fig. 9.

Either a semiconductor element device or a semiconductor package device as defined above may be employed as the high density semiconductor device in the board of Fig. 8. Hence the high density semiconductor device comprises BUMPs arranged in a grid pattern. Fig. 8 illustrates a high density printed wiring board 21 (hereinafter referred to simply as a board 21) to which the semiconductor device 1 (hereinafter referred to only as the device 1) is mounted using contact wires 113. Via pads 6 are arranged in the vicinity of the terminal pads 3 in a one-to-one relationship inside the terminal pads region R1. As shown in Fig. 9, the terminal pads are arranged in a grid pattern, and each via pad 6 is placed above and to the right of the corresponding terminal pad 3 as seen in the Figure. The via pads are in general located at the crossing points of lines drawn midway between the rows and columns of the terminal pad grid. Each terminal pad 3 and corresponding via pad 6 are connected by a surface wiring pattern 8. The modification pads 500 are arranged in a line around the outside of the terminal pads region R1, and as a result the region R2 is remarkably reduced in size in comparison with the arrangement of Fig. 5 for example.

In Figs. 8 and 9, suppose that the destinations of the terminal pads 357 and 366 are to be modified. In this case, the surface wiring pattern 857 (866) which connects the terminal pads 357 (366) and the via pad 657 (666) is cut, a discrete surface wiring (wire) 75 (77) is connected to the modification pad 501 (502) from the terminal pad 357 (366), and the discrete surface wiring 76 (78) is connected to the new destination circuit from the modification pad 501 (502). Modification of the destination of these two terminal pads is thereby performed. The modification pads 501 and 502 are selected as the pads nearest the terminal pads 357 and 366. It will not be required to modify the destinations of all terminal pads in the region R1, and therefore the number of modification pads 500 is allowed to be less than the total number of terminal pads 3.

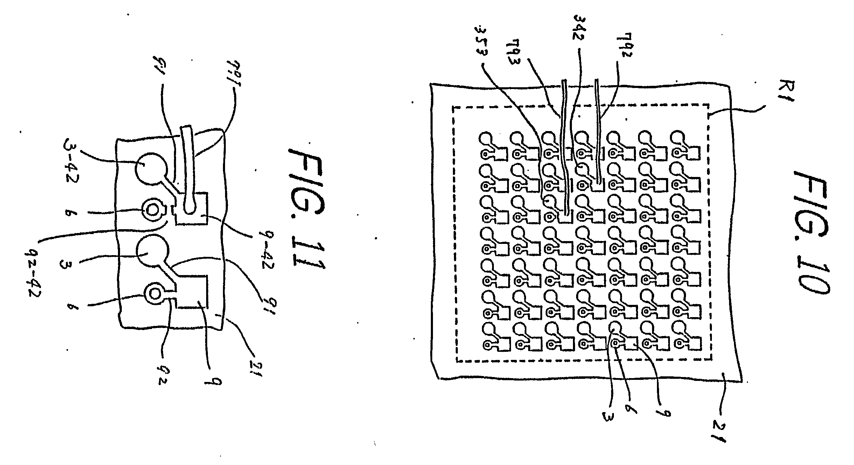

In an embodiment of the present invention, not only the via pads but also the modification pads are provided inside the region R1, as shown in Figs. 10 and 11. Fig. 10 shows part of the interior of the terminal pads via R1 and two discrete surface wirings for modifying the destinations of two terminal pads. In Fig. 10, a respective via pad 6 is arranged in the vicinity of each terminal pad 3. The via pads 6 are generally located midway between adjacent terminal pads 3 in the rows of terminal pads as seen in the Figure. In addition, a respective modification pad 9 is also arranged in the vicinity of each terminal pad 3, located to the upper right of the terminal pad 3 in a similar way to the arrangement of via pads in the previously described board.

Fig. 11 illustrates in detail the positional relationship of the terminal pads 3, the modification pads 9 and the via pads 6. Fig. 11 depicts an enlarged part of Fig. 10 showing discrete surface wirings for modifying the destinations of the terminal pads. As illustrated in Fig. 11, the terminal pads 3 and modification pads 9, and modification pad 9 and via pad 6, are connected by surface wiring patterns 91 and 92 respectively. Therefore, the destination of a terminal pad 3–42 can be changed by cutting a surface wiring pattern 92–42 and newly connecting a wire (discrete surface wiring) 791 to a modification pad 9–42. The cutting and connecting can be easily done on the surface of the board 21.

The pattern of pads in the region R1 is more complex in the board shown in Fig. 10 than that in the board shown in Figs. 8 and 9, but the associated pads are all housed within region R1 and as a result, the region R2 is eliminated and thereby packing density of the devices 1 on the board 21 can be further improved. However, when the number of terminal pads is too great, the embodiment of the invention shown in Fig. 10 is not so useful, because of the more complex pad arrangement.

In the above-described embodiment, a high density semiconductor device is shown mounted to a high density printed wiring board through contact wires, but this is not essential to the invention. For example, a device having a small number of input and output terminals can alternatively be directly mounted to the terminal pads by joining the BUMPs and respective terminal pads.

As explained above, the present invention concerns a high density printed wiring board, on which terminal leads are provided and to which high density semiconductor devices having input and output terminals are mounted using the terminal pads. Respective via pads, each internally connected with previously designated circuits of the board, are placed nearby each terminal pad and each is electrically connected with the respective terminal pad by a wiring pattern provided on the surface of the board. When the destination of a terminal pad is required to be modified for connection to a different circuit of the board, the wiring pattern is severed and electrical connection between the terminal pad and the different circuit is performed by an insulated discrete wire wired on to the surface of the board. Modification pads for relaying the discrete wires are provided on the surface of the board distributed within the terminal region so that a modification pad is provided near to each terminal pad and via pad.

**Claims**

1. A printed wiring board, for mounting a semiconductor device having input terminals and output terminals, said board including internal wirings and comprising:

a plurality of terminal pads (3) provided on a surface of the printed wiring board for electrical connection to the input and output terminals of the semiconductor device, and forming a terminal pads region (R1) on the surface of the printed wiring board;

and a plurality of via pads (6) provided within said terminal pads region (R1) such that each via pad (6) is positioned near a respective said terminal pad (3), for electrically connecting said terminal pads (3) to said internal wirings of the board, each via pad (6) being internally connected to a said internal wiring providing a connection to a previously designated circuit of the board, and being connected with its respective terminal pad (3); and characterised by:

a plurality of modification pads (9) provided within the terminal pads region (R1), each one being located near a respective terminal pad (3) and via pad (6) for electrically relaying a connection from said terminal pad (3) to a different circuit, not said previously designated circuit, of the printed wiring board.

2. A printed wiring board according to claim 1, further comprising a plurality of first surface wiring patterns (91) provided on the surface of the board for electrically connecting each said modification pad (9) to its respective terminal pad (3).

3. A printed wiring board according to claim 2, further comprising a plurality of second surface wiring patterns (92) provided on the surface of the board for electrically connecting each said modification pad (9) to its respective via pad (6), each second surface wiring pattern (92) having a mechanical structure capable of being severed when the corresponding terminal pad (3) is to be connected with a different circuit, not said previously designated circuit, of the printed wiring board.

4. A printed wiring board according to claim 1, 2 or 3, wherein said terminal pads (3) are arranged in a grid pattern having an equal pitch in first and second directions, said via pads (6) are arranged so that each via pad is equally spaced between two adjacent terminal pads (3) along the first direction of the grid, and said modification pads (9) are arranged so that each modification pad is equally spaced from each of four terminal pads (3) which are closest to it.

**Patentansprüche**

1. Gedruckte Verdrahtungskarte, zur Montage einer Halbleitervorrichtung, die Eingangsanschlüsse und Ausgangsanschlüsse hat, welche Karte interne Verdrahtungen hat und umfaßt:

eine Vielzahl von Anschlußpads (3), die auf der Oberfläche der gedruckten Verdrahtungskarte für die elektrische Verbindung mit den Eingangs- und Ausgangsanschlüssen der Halbleitervorrichtung vorgesehen sind und einen Anschlußpadbereich (R1) auf der Oberfläche der gedruckten Verdrahtungskarte bilden;

und eine Vielzahl von Durchgangspads (6), die innerhalb des genannten Anschlußpadbereichs (R1) derart vorgesehen sind, daß jedes Durchgangspad (6) nahe einem genannten entsprechenden Anschlußpad (3) vorgesehen ist, um die genannten Anschlußpads (3) mit den internen Verdrahtungen der Karte zu verbinden, wobei jedes Durchgangspad (6) intern mit einer genannten internen Verdrahtung verbunden ist, die eine Verbindung mit einer zuvor bestimmten Schaltung auf der Karte herstellt und mit ihrem entsprechenden Anschlußpad (3) verbunden ist, und gekennzeichnet durch:

eine Vielzahl von Modifikationspads (9), die in dem Anschlußpadbereich (R1) vorgesehen sind, wobei jedes einzelne nahe einem entsprechenden Anschlußpad (3) und einem Durchgangspad (6) angeordnet ist, um eine elektrische Verbindung von dem Anschlußpad (3) zu einer anderen Schaltung, nicht der vorher bestimmten Schaltung, der gedruckten Schaltungskarte herzustellen.

2. Gedruckte Verdrahtungskarte nach Anspruch 1, ferner mit einer Vielzahl von ersten Oberflächenverdrahtungsmustern (91), die auf der Oberfläche der Karte für die elektrische Verbindung jedes genannten Modifikationspads (9) mit seinem jeweiligen Anschlußpad (3) vorgesehen sind.

3. Gedruckte Verdrahtungskarte nach Anspruch 2, ferner mit einer Vielzahl von zweiten Oberflächenverdrahtungsmustern (92), die auf der Oberfläche der Karte für die elektrische Verbindung jedes genannten Modifikationspads (9) mit seinem jeweiligen Durchgangspad (6) vorgesehen sind, wobei jedes zweite Oberflächenverdrahtungsmuster (92) eine mechanische Struktur hat, die fähig ist, abgetrennt zu werden, wenn das entsprechende Anschlußpad (3) mit einer anderen Schaltung, nicht der genannten zuvor bestimmten Schaltung, der gedruckten Verdrahtungskarte verbunden werden soll.

4. Gedruckte Verdrahtungskarte nach Anspruch 1, 2 oder 3, bei der die genannten Anschlußpads (3) in einem Gittermuster angeordnet sind, welches gleiche Teilungen in der ersten und zweiten Richtung hat, welche genannten Durchgangspads (6) so angeordnet sind, daß jedes Durchgangspad den gleichen Abstand zwischen zwei benachbarten Anschlußpads (3) längs der ersten Richtung des Gitters hat, und die genannten Modifikationspads (9) so angeordnet sind, daß jedes Modifikationspad den gleichen Abstand von jedem der vier Anschlußpads (3) hat, welche ihm am nächsten sind.

**Revendications**

1. Plaquette de circuit imprimé, servant au montage d'un dispositif semiconducteur possédant des bornes d'entrée et des bornes de sortie, ladite plaquette comportant des câblages internes et comprenant:

plusieurs plots de bornes (3) disposés sur une surface de la plaquette de circuit imprimé pour la connexion électrique avec les bornes d'entrée et de sortie du dispositif semiconducteur et formant une région (R1) de plots de bornes à la surface de la plaquette de circuit imprimé; et

plusieurs plots de passages (6) disposés à l'intérieur de ladite région de plots de bornes (R1) de façon que chaque plot de passage (6) soit placé à proximité d'un dit plot de borne respectif (3), afin de connecter électriquement lesdits plots de bornes (3) avec lesdits câblages internes de la plaquette, chaque plot de passage (6) étant connecté intérieurement à un dit câblage interne produisant la connexion avec un circuit désigné à l'avance de la plaquette et étant connecté avec son plot de borne respectif (3); et caractérisée par:

plusieurs plots de modification (9) disposés à l'intérieur de la région de plots de bornes (R1), qui sont chacun placés au voisinage d'un plot de borne respectif (6) afin de servir de relais électrique à une connexion allant dudit plot de borne (3) à un circuit désigné à l'avance, de la plaquette de circuit imprimé.

2. Plaquette de circuit imprimé selon la revendication 1, comrprenant en outre plusieurs premières configurations de câblage de surface (91) disposées à la surface de la plaquette pour connecter électriquement chaque dit plot de modification (9) à son plot de borne respectif (3).

3. Plaquette de circuit imprimé selon la revendication 2, comprenant en outre plusieurs deuxièmes configurations de câblage de surface (92) disposées à la surface de la plaquette pour connecter électriquement chaque dit plot de modification (9) à son plot de passage respectif (6), chaque deuxième configuration de câblage de surface (92) possédant une structure mécanique qui est susceptible d'être coupée lorsque le plot de borne correspondant (3) doit être connecté avec un circuit différent, et non pas ledit circuit désigné à l'avance, de la plaquette de circuit imprimé.

4. Plaquette de circuit imprimé selon la revendication 1, 2 ou 3, où lesdits plots de bornes (3) sont disposées suivant une configuration de grille dont les pas sont égaux suivant une première et une deuxième direction, lesdits plots de passage se trouve à égale distance de deux plots de bornes (3) adjacents suivant la première direction de la grille, et lesdits plots de modification (9) sont disposés de façon que chaque plot de modification soit également écarté de chacun des quatre plots de bornes (3) qui sont le plus près de lui.

FIG. 1

FIG. 2

FIG. 3

# FIG. 4

(a)

(b)

# FIG. 5

(a)

(b)

## FIG. 6

## FIG. 7

## FIG. 8

## FIG. 9

# FIG. 10

# FIG. 11